# EUROPEAN PATENT APPLICATION

(11) **EP 1 806 776 A1**
(43) Date of publication of application: **11.07.2007**
(21) Application number: 05790479.9
(22) Date of filing: 04.10.2005
(51) Int. Cl.: H01L 21/314, C23C 16/26

(54) **PLASMA FILM FORMING METHOD AND PLASMA FILM FORMING DEVICE**

(30) Priority: 05.10.2004 JP 2004292744; 22.09.2005 JP 2005276202
(71) Applicant: Tokyo Electron Ltd., Tokyo 107-8481 (JP)
(72) Inventor: KOBAYASHI, Yasuo, c/o Tokyo Electron Limited,, Nirasaki-shi, Yamanashi 4070192 (JP); OHTA, Tomohiro, 2790013 (JP); KANG, Songyun, c/o Tokyo Electron Limited,, Nirasaki-shi, Yamanashi 4070192 (JP); SAWADA, Ikuo, c/o Tokyo Electron Limited,, Nirasaki-shi, Yamanashi 4070192 (JP)
(74) Representative: Liesegang, Eva
(86) International application number: PCT/JP2005/018364
(87) International publication number: WO 2006/038623

(57) **Abstract**

For a substrate (W) placed in an airtight processing vessel (1), plasma is generated by introducing a microwave to a radial line slot antenna (4). Conditions are set such that the pressure in the processing vessel is in the range of from 7.32Pa to 8.65Pa, the microwave power is in the range of from 2000W to 2300W, the distance (L1) between the surface of the substrate and an opposed face of a raw-material supply member (3) is in the range of from 70mm to 105mm, and the distance (L2) between the surface of the substrate and an opposed face of a discharge gas supply member (2) is in the range of from 100mm to 140mm. Under these conditions, a raw-material gas consisting of a cyclic C₅F₈ gas is activated based on energy of the microwave. Consequently, film-forming species containing C₄F₆ ions and/or C₄F₆ radicals in a greater content can be obtained. Thus, a fluorine-added carbon film excellent in the leak properties and heat stability can be securely formed.

## Description

### TECHNICAL FIELD

The present invention relates a technology for forming a fluorine-added carbon film (fluorocarbon film) by utilizing plasma.

### BACKGROUND ART

As one approach for achieving highly integrated semiconductor devices, a multilayered wiring structure has been employed. In order to take a form of such a multilayered wiring structure, each pair of adjacent wiring layers are connected via an electrically conductive layer while a thin film which is called "interlayer isolation film" is formed in areas other than the conductive layer. As a typical example of the interlayer isolation film, a silicon oxide film is usually known. However, there is a need for reducing the dielectric constant of the interlayer isolation film in order to make the operating speed of the device significantly higher.

In such a situation, a fluorine-added carbon film which can reduce the dielectric constant to a greater extent as compared with the silicon oxide film has attracted significant attention. The fluorine-added carbon film is formed from film-forming species to be obtained by changing a row-material gas consisting of carbon (C) and fluorine (F) into plasma. As the row-material gas, C₄F₈ gases or C₅F₈ gases are known. It has been found that the use of the C₅F₈ gas makes it easier that the decomposed products create a three-dimensional structure and renders the C-F bond significantly strong. As a result, an interlayer insulation film, which has a lower dielectric constant, generates a lower leak current, and is excellent in the heat stability, can be obtained.

In JP11-162960A, a technology for forming a fluorine-added carbon film by using a cyclicly structured C₅F₈ gas as a row-material gas is described. Specifically, a plasma generating gas, such as an Ar gas, is changed into plasma by electron cyclotron resonance (ECR), and a C₅F₈ gas is then activated by the so-produced plasma, so as to form a fluorine-added carbon film onto a semiconductor wafer (hereinafter, referred to as a wafer).

However, even in the case of using the C₅F₈ gas as the raw-material gas, it has been recognized that the film properties including the leak current, heat stability and the like are often changeable among the films formed. The inventors consider that the film properties of the fluorine-added carbon film are highly related to the film forming conditions. Specifically, we recognize that film-forming species to be formed from the C₅F₈ gas can vary with the film forming conditions, and the film properties may change depending on the difference in such film species. Accordingly, we consider that by rendering the film forming conditions more appropriate, a fluorine-added carbon film having superior film properties can be obtained.

### DISCLOSURE OF INVENTION

The present invention was made in such a situation, and it is therefore an object of this invention to provide a plasma film forming method or plasma film forming apparatus, which can form a fluorine-added carbon film having superior properties, such as the leak properties and heat stability, by producing desired film species by rendering the film forming conditions more appropriate. It is also an object of the present invention to provide a storage medium which stores a program for controlling the plasma film forming apparatus such that it can perform the intended film forming process.

To achieve the object described above, the present invention provides a plasma film forming method for forming a fluorine-added carbon film, from film-forming species containing C₄F₆ or C₄F₅ obtained by activating a raw-material gas of a compound consisting of carbon and fluorine and having one triple bond, one or more double bonds or conjugated double bond, based on energy of a microwave,
wherein the raw-material gas is activated to make a concentration of the raw-material gas after activation in the range of from 0.05 times to 0.5 times a concentration of the raw-material gas before activation.

For example, the compound having one triplet bond is Octafluoropentyne. For example, the compound having one or more double bonds is selected from the group consisting of Octafluorocyclopentene, Decafluorocyclohexene, Octafluorocyclohexadiene. For example, the compound having conjugated double bond is Octafluoropentadiene.

The present invention also provides a plasma film forming apparatus for forming a fluorine-added carbon film on a surface of a substrate, from film-forming species containing C₄F₆ or C₄F₅ obtained by activating a raw-material gas of a compound consisting of carbon and fluorine and having one triple bond, one or more double bonds or conjugated double bond, based on energy of a microwave, the apparatus comprising:
an airtight processing vessel in which a table for placing the substrate thereon is provided;
an exhaust system configured to discharge an atmosphere in the processing vessel;
a raw-material gas supply system configured to supply the raw-material gas into the processing vessel at a controlled flow rate;
a raw-material gas supply member having a face opposed to the table, the opposed face being formed with raw-material gas supply holes, the raw-material gas supply member being configured to discharge the raw-material gas supplied from the raw-material gas supply system into the processing vessel via the supply holes;
a radial line slot antenna provided opposing to the table;
a microwave supply system configured to supply a microwave to the antenna at a controlled power; and
a controller configured, upon forming the film, to control the exhaust system, the raw-material gas supply system and the microwave supply system to activate the raw-material gas to make a concentration of the raw-material gas after activation in the range of from 0.05 times to 0.5 times a concentration of the raw-material gas before activation.

The present invention also provides a plasma film forming apparatus for forming a fluorine-added carbon film on the surface of a substrate, from film-forming species containing C₄F₆ or C₄F₅ obtained by activating a raw-material gas of a compound consisting of carbon and fluorine and having one triple bond, one or more double bonds or conjugated double bond, based on energy of a microwave, the apparatus comprising:
an airtight processing vessel in which a table for placing the substrate thereon is provided;
an exhaust system configured to discharge an atmosphere in the processing vessel;
a raw-material gas supply system configured to supply the raw-material gas into the processing vessel at a controlled flow rate;
a raw-material gas supply member having a face opposed to the table, the opposed face being formed with raw-material gas supply holes, the raw-material gas supply member being configured to discharge the raw-material gas supplied from the raw-material gas supply system into the processing vessel via the supply holes;
a discharge gas supply system configured to supply a discharge gas into the processing vessel at a controlled flow rate;
a discharge gas supply member having a face opposed to the table, the opposed face being formed with discharge gas supply holes, the discharge gas supply member being configured to discharge the discharge gas supplied from the discharge gas supply system into the processing vessel via the supply holes;
a radial line slot antenna provided opposing to the table; and
a microwave supply system configured to supply a microwave to the antenna at a controlled power,
wherein the distance between the surface of the substrate on the table and the opposed face of the raw-material gas supply member is in the range of from 70mm to 105mm,
wherein the distance between the surface of the substrate on the table and the opposed face of the discharge gas supply member is in the range of from 100mm to 140mm, and
wherein the apparatus further comprises a controller configured, upon forming the film, to control the exhaust system, the raw-material gas supply system and the discharge gas supply system to make a pressure in the processing vessel in the range of from 7.32Pa to 8.65Pa as well as to control the microwave supply system to make the power of the microwave supplied to the antenna member in the range of from 2000W to 2300W.

It should be appreciated that unlike the raw-material gas, the "discharge gas" is a gas of a material which does not generate a deposit by itself even when changed into plasma, and, for example, the argon gas or krypton gas can be mentioned as the discharge gas.

In the present invention, the expression of "activating a raw-material gas based on energy of a microwave" is contemplated to include both of the case in which the raw-material gas itself is activated by directly changing it into plasma by using energy of a microwave and the case in which the discharge gas is first changed into plasma by using energy of a microwave and the raw-material gas is then activated by the discharged gas having been changed into plasma.

The present invention also provides a storage medium for use in forming a fluorine-added carbon film on the surface of a substrate, from film-forming species containing C₄F₆ or C₄F₅ obtained by activating a raw-material gas of a compound consisting of carbon and fluorine and having one triple bond, one or more double bonds or conjugated double bond, based on energy of a microwave, by using a plasma film forming apparatus comprising:
an airtight processing vessel in which a table for placing the substrate thereon is provided;
an exhaust system configured to discharge an atmosphere in the processing vessel;
a raw-material gas supply system configured to supply the raw-material gas into the processing vessel at a controlled flow rate;
a raw-material gas supply member having a face opposed to the table, the opposed face being formed with raw-material gas supply holes, the raw-material gas supply member being configured to discharge the raw-material gas supplied from the raw-material gas supply system into the processing vessel via the supply holes;
a radial line slot antenna provided opposing to the table; and
a microwave supply system configured to supply a microwave to the antenna at a controlled power,
wherein the storage medium stores therein a program configured to control the exhaust system, the raw-material gas supply system and the microwave supply system to activate the raw-material gas to make a concentration of the raw-material gas after activation in the range of from 0.05 times to 0.5 times a concentration of the raw-material gas before activation.

The present invention also provides a storage medium for use in forming a fluorine-added carbon film on the surface of a substrate, from film-forming species containing C₄F₆ or C₄F₅ obtained by activating a raw-material gas of a compound consisting of carbon and fluorine and having one triple bond, one or more double bonds or conjugated double bond, based on energy of a microwave, by using a plasma film forming apparatus comprising:
an airtight processing vessel in which a table for placing the substrate thereon is provided;
an exhaust system configured to discharge an atmosphere in the processing vessel;
a raw-material gas supply system configured to supply the raw-material gas into the processing vessel at a controlled flow rate;
a raw-material gas supply member having a face opposed to the table, the opposed face being formed with raw-material gas supply holes, the raw-material gas supply member being configured to discharge the raw-material gas supplied from the raw-material gas supply system into the processing vessel via the supply holes;
a discharge gas supply system configured to supply a discharge gas into the processing vessel at a controlled flow rate;
a discharge gas supply member having a face opposed to the table, the opposed face being formed with discharge gas supply holes, the discharge gas supply member being configured to discharge the discharge gas supplied from the discharge gas supply system into the processing vessel via the supply holes;
a radial line slot antenna provided opposing to the table; and
a microwave supply system configured to supply a microwave to the antenna at a controlled power,
wherein the distance between the surface of the substrate on the table and the opposed face of the raw-material gas supply member is in the range of from 70mm to 105mm,
wherein the distance between the surface of the substrate on the table and the opposed face of the discharge gas supply member is in the range of from 100mm to 140mm, and
wherein the storage medium stores therein a program configured to control the exhaust system, the raw-material gas supply system and the discharge gas supply system to make a pressure in the processing vessel in the range of from 7.32Pa to 8.65Pa as well as to control the microwave supply system to make the power of the microwave supplied to the antenna member in the range of from 2000W to 2300W.

According to the present invention, film-forming species containing the C₄F₆ and/or C₄F₅ at a higher content can be obtained selectively from decomposition of the raw-material gas by rendering the activated state of the raw-material gas due to plasma more appropriate. By forming a film using such film-forming species, a fluorine-added carbon film which has excellent properties including the leak properties and heat stability can be obtained.

### BRIEF DESCRIPTION OF DRAWINGS

Fig. 1 is a vertical cross section showing one embodiment of a plasma film forming apparatus according the present invention.
Fig. 2 is a plan view showing a raw-material gas supply member used in the film forming apparatus of Fig. 1.
Fig. 3 is a perspective view showing an antenna portion partly in cross section, which is used in the film forming apparatus of Fig. 1.
Fig. 4 is a diagram showing compounds as the raw-material gas used in the film forming apparatus of Fig. 1.
Fig. 5 is a diagram showing compounds as the raw-material gas used in the film forming apparatus of Fig. 1.
Fig. 6 is a diagram showing expected decomposition of a C₅F₈ gas when the C₅F₈ gas is changed into plasma.
Fig. 7 is a graph showing the relationship between the leak current and the pressure as the result obtained by performing an experiment to determine the pressure condition upon forming a film.
Fig. 8 is a graph showing the relationship between the leak current and the microwave power as the result obtained by performing an experiment to determine the microwave power condition upon forming a film.
Fig. 9 is a graph showing the relationship between the leak current and the distance as the result obtained by performing an experiment to determine the distance, as one of the film forming conditions, between the surface of a wafer and an opposed face of a raw-material gas supply member.
Fig. 10 is a graph of spectra obtained by a mass spectrometry for a C₅F₈ gas in the case of not changing the C₅F₈ gas into plasma.
Fig. 11 is a graph of spectra obtained by a mass spectrometry for a C₅F₈ gas in the case of changing the C₅F₈ gas into plasma.

### BEST MODE FOR CARRYING OUT THE INVENTION

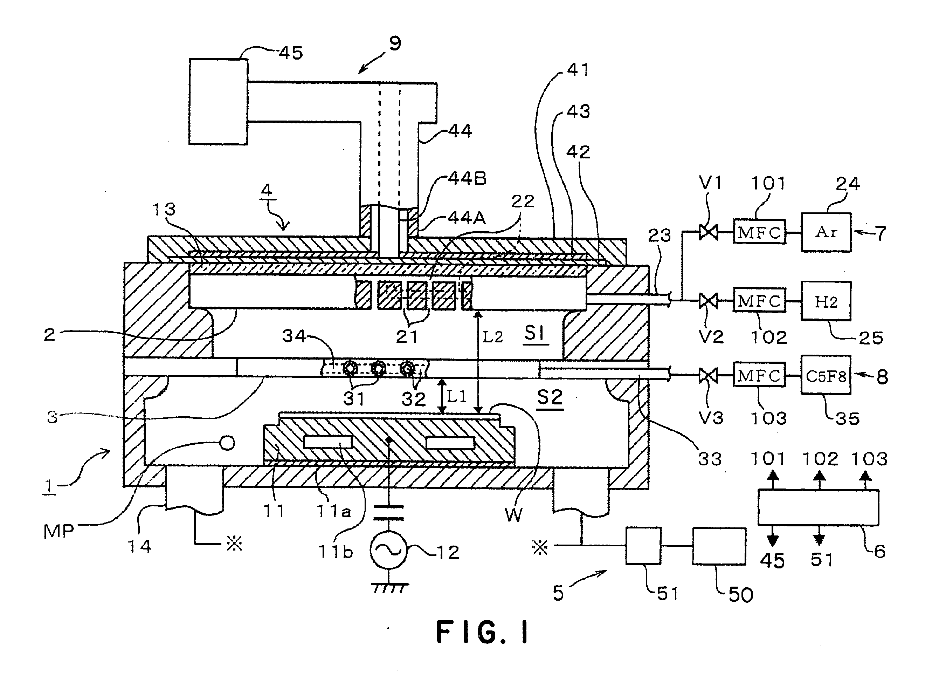

Hereinafter, one embodiment of a plasma film forming apparatus according to the present invention will be described. This plasma film forming apparatus is a chemical vapor deposition (CVD) apparatus configured to generate plasma by using a radial line slot antenna (RLSA). The plasma film forming apparatus shown in Fig. 1 includes a cylindrical airtight processing vessel 1. The side walls and the bottom portion of the processing vessel 1 are comprised of a conductor, for example, aluminum-added stainless steel, and a protective film consisting of oxidized aluminum is formed on the inner wall surface.

In the processing vessel 1, a table 11 for placing a wafer (substrate) W thereon is provided at approximately the center of the bottom face via an insulating material 11a. The table 11 consists of aluminum nitride (AIN) or oxidized aluminum (Al₂O₃), for example. In the interior of the table 11, a cooling jacket 11b configured to circulate a cooling medium therein as well as a heater (not shown) constituting a temperature control system together with the cooling jacket 11b are provided. The top face of the table 11b is configured as an electrostatic chuck. In the table 11, an electrode (not shown), to which a high frequency power source 12 for 13.56Hz bias, for example, is connected, is incorporated, so as to draw ions existing in plasma therein with a higher vertical directivity, by bringing the surface of the table 11 into a negative potential due to the biasing high frequency.

The ceiling of the processing vessel 1 is covered airtightly with a discharge gas supply member 2 formed from aluminum oxide, for example, and having a generally disk-like shape. In the bottom face of the discharge gas supply member 2, which is opposed to the table 11, a plurality of discharge gas supply holes 21 are formed. The gas supply holes 21 are respectively in fluid communication with a discharge gas supply passage 23, via a gas flowing passage 22 formed in the supply member 2. The discharge gas supply passage 23 is connected with an argon (Ar) gas supply source 24, the argon gas being used as a discharge gas, as well as connected with a hydrogen (H2) gas supply source 25. The respective gasses supplied from the supply sources 24, 25 travel through the discharge gas supply passage 23 and gas flowing passage 22, and are discharged uniformly from the gas supply holes 21 toward the space below the supply member 2. The distance L2 between the bottom face (opposed face) of the discharge gas supply member 2 and the surface of a wafer W placed on the table 11 is set within the range of 100mm to 140mm.

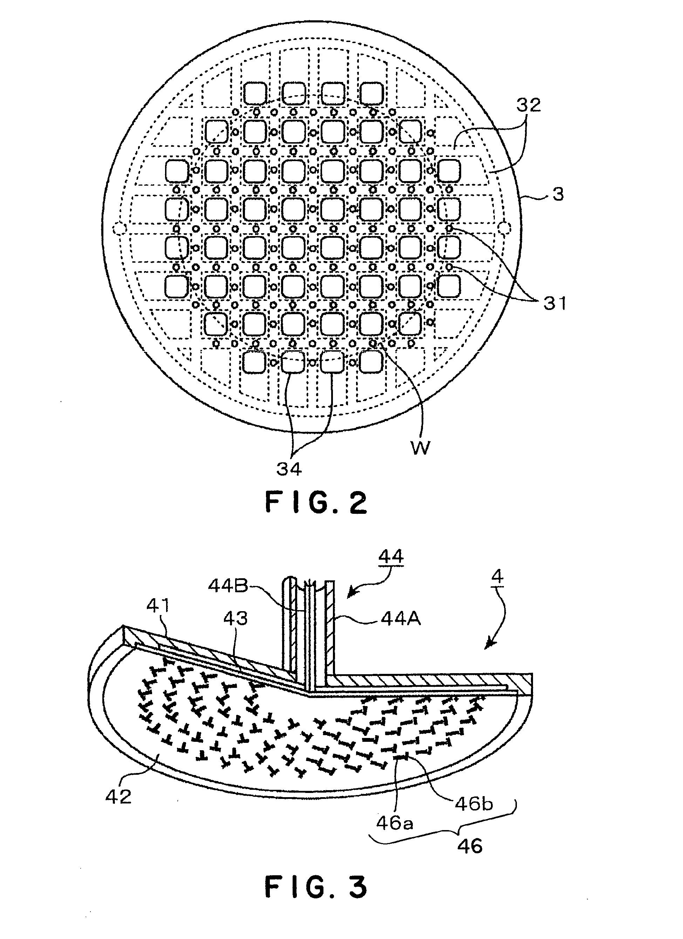

Between the table 11 and the discharge gas supply member 2, a raw-material gas supply member 3 is provided, which has a generally disk-like shape and is formed from a conductor, such as an aluminum alloy containing magnesium (Mg), aluminum-added stainless steel and the like. The raw-material gas supply member 3 divides the interior space of the processing vessel 1 into an upper plasma generation space S1 and a lower processing space S2. In the bottom face of the supply member 3, which is opposed to the table 11, a plurality of raw-material gas supply holes 31 are formed. As is also shown in Fig. 2, these gas supply holes 31 are respectively in fluid communication with a raw-material gas supply passage 33, via a gas flowing passage 32 formed into a lattice-like structure in the supply member 3. The raw-material gas supply passage 33 is connected with a supply source 35 of a C₅F₈ gas as the raw-material gas. The raw-material gas supplied from the supply source 35 passes through the raw-material gas supply passage 33 and the gas flowing passage 32, and is discharged uniformly from the gas supply holes 31 toward the space below the supply member 3. The distance L1 between the bottom face (opposed face) of the raw-material gas supply member 3 and the surface of the wafer W placed on the table 11 is set within the range of from 70mm to 105mm.

As is also shown in Fig. 2, in the raw-material gas supply member 3, a plurality of vertical through-holes 34 are formed. These through-holes 34 are provided for passing plasma and/or raw-material gas downward therethrough, each hole 34 being arranged between adjacent gas flowing passages 32.

In Fig. 1, those denoted by reference characters V1, V2, V3 are valves, and those designated by reference numerals 101, 102, 103 are mass flow controllers (MFC). A discharge gas supply system 7, which is configured to supply the argon gas used as the discharge gas at a controlled flow rate, is composed mainly of the argon gas supply source 24 and the MFC 101. In addition, a raw-material gas supply system 8, which is configured to supply the raw-material gas at a controlled flow rate, is composed mainly of the C₅F₈ gas supply source 35 and the MFC 103.

On the discharge gas supply member 2, a cover plate 13 is airtightly attached, which is formed of a dielectric, such as aluminum oxide. Further, on the cover plate 13, an RLSA 4 is provided. The RLSA 4, as is also shown in Fig. 3, includes an antenna body 41 which is composed of a substantially disk-like conductor, and a plane antenna member (slot plate) 42 which is attached to the bottom face of the antenna body 41 and formed of a disk-like conductor. With these antenna body 41 and plane antenna member 42, a flat hollow circular wave guide is constructed. Between the plane antenna member 42 and the antenna body 41, a lagging plate 43 is provided, which is formed of a low-loss dielectric material, such as aluminum oxide or silicon nitride (Si₃N₄), for example. The lagging plate 43 is used for shortening the guide wave length in the circular wave guide for micro waves.

The RLSA 4 constructed as described above is mounted to the processing vessel 1 via a sealing member (not shown) such that the plane antenna member 42 is closely contacted with the cover plate 13. The RLSA 4 is connected with a microwave generator 45 which is power-controllable via a coaxial wave guide 44. With the wave guide 44 and microwave generator 45, a microwave supply system 9 is configured to supply a 2.45 GHz or 8.3 GHz microwave, for example, to the RLSA 4 at a controlled power. A wave guide 44A disposed outside the coaxial wave guide 44 is connected with the antenna body 41, and an inner central conductor 44B extends through the lagging plate 43 and is connected with the plane antenna member 42.

The plane antenna member 42 is formed of a copper plate with a thickness of approximately 1mm, for example, in which many slot portions 46 are formed as shown in Fig. 3. Each slot portion 46 is formed into a generally T-like shape, including a pair of slots 46a, 46b positioned to be slightly spaced away from each other. The slot portions 46 are arranged along the circumference of the plane antenna member 42 so as to be concentric or spiral, for example. In such a way, since the slot 46a and slot 46b are arranged to be substantially orthogonal to each other in each slot portion 46, a circular polarization can be radiated therefrom, which includes two orthogonal polarization components. In this case, by arranging each pair of slots 46a, 46b at an interval corresponding to the wave length of the microwave to be compressed by the lagging plate 43, the microwave is radiated from a plane antenna member 71 as a substantially plane wave.

Specifically, the slot length of each slot 46a, 46b is sized to be less than half of the wave length of the microwave on the side of the coaxial wave guide 44 in the plane antenna member 42, but larger than half of the wave length of the microwave on the side of the plasma generation space S1 in the plane antenna member 42. Consequently, while the microwave can enter the plasma generation space S1 through each slot portion 46, the microwave once entered the plasma generation space S1 can not return therefrom to the space on the side of the coaxial wave guide 44. At the bottom face of the plane antenna member 42, a plurality of slit portions 46 are arranged concentrically, with the interval in the radial direction between the slit portions 46 being set at half of the wave length of the microwave on the side of the coaxial wave guide 44, for example.

To the bottom of the processing vessel 1, an exhaust pipe 14 is connected, the exhaust pipe 14 being connected in turn with a vacuum pump 50 via an exhaust gas pressure controller 51. With the exhaust pipe 14, vacuum pump 50 and exhaust gas pressure controller 51, an exhaust system 5 is configured to discharge the atmosphere in the processing vessel 1 at a controlled exhaust pressure.

This plasma film forming apparatus further comprises a controller 6 for controlling the exhaust system 5 (exhaust gas pressure controller 51), raw-material gas supply system 8 (MFC 103), discharge gas supply system 7 (MFC 101, 102) and microwave supply system 9 (microwave generator 45). In addition, the controller 6 also controls the high frequency power source 12, valves V1 to V3 and the like. The controller 6 performs a control program produced to carry out formation of a fluorine-added carbon film under predetermined film forming conditions. Such a program may be stored in a storage medium, such as a flexible disk, compact disk, flash memory, MO (Magneto-Optical Disk) or the like.

Next, the plasma film forming method of the present invention, which is carried out by using the aforementioned apparatus, will be described.

First, a wafer W having aluminum wires formed on its surface, for example, is carried in the processing vessel 1 and placed on the table 11. Subsequently, while discharging the atmosphere in the processing vessel 1 by using the exhaust system 5, the Ar gas is supplied at a flow rate of 300sccm, for example, through the discharge gas supply member 2 from the discharge gas supply system 7, and the C₅F₈ gas is supplied at a flow rate of 150sccm, for example, through the raw-material gas supply member 3 from the raw-material gas supply system 8, into the processing vessel 1, respectively. Thereafter, the internal space of the processing vessel 1 is maintained at a predetermined processing pressure, for example, within the range of from 7.32Pa (55mTorr) to 8.65Pa (65mTorr), for example, 7.7 Pa. The surface temperature of the table 11 is elevated, in advance, up to 380°C.

On the other hand, a microwave of 2.45GHz and 2000W to 2300W is supplied to the RLSA 4 via the microwave supply system 9. Specifically, the microwave generated by the microwave generator 45 is propagated through the coaxial wave guide 44, in the TM mode, TE mode and/or TEM mode, and reaches the plane antenna member 42 of the RLSA 4. The microwave that has reached the plane antenna member 42 is emitted downward into the plasma generation space S1 through each slot portion 46, cover plate 13 and then discharge gas supply member 2 while it is propagated radially from the central portion toward the peripheral regions of the plane antenna member 42.

Since the cover plate 13 and the discharge gas supply member 2 are formed of aluminum oxide which is transparent to the microwave, the microwave can be transmitted well therethrough. With the slit configuration of the plane antenna member 42 as describe above, a circular polarization can be emitted uniformly over the plane of the plane antenna member 42, resulting in a uniform electric field density in the lower plasma generation space S1. Due to the energy of the microwave, uniform plasma generated from the discharge gas is excited at a high density throughout the plasma generation space S1.

The plasma generated from the discharge gas then flows into the lower processing space S2 through the holes 34 of the raw-material supply member 3, thereby activating the C₅F₈ gas to be supplied into the processing space S2 from the supply member 3.

Once the C₅F₈ gas is activated in such a manner, it is decomposed, and C₄F₆ ions or C₄F₆ radicals are generated as active species as described below, resulting in formation of film-forming species containing the C₄F₆ ions or C₄F₆ radicals at a higher content. Consequently, the film-forming species that has reached the surface of the wafer W is formed into a fluorinated carbon (CF) film. At this time, due to the bias voltage used for drawing plasma, the Ar ions contained in the discharge gas plasma are drawn toward the surface of wafer W, as such CF film portions formed at corners of a pattern on the surface of wafer W are collapsed and removed by the so-called spatter etching effect. Thus, while the distance between the respective pattern grooves is increased, the CF film is formed initially from the bottom potion of the pattern grooves, and also embedded in the pattern grooves. The wafer on which the CF film is formed in such a way is then carried out from the processing vessel 1.

As described above, if forming a fluorine-added carbon film by using the aforementioned plasma film forming apparatus which uses a C₅F₈ gas as a raw-material gas and utilizes the RLSA, wherein the raw material gas is changed into plasma under the conditions:
the pressure in the processing vessel is in the range of from 7.32Pa (55mTorr) to 8.65Pa (65mTorr) inclusive;
the microwave power is in the range of from 2000W to 2300W inclusive (or from 1.88W/cm² to 2.16W/cm² inclusive, because the diameter of the antenna member 42 is 368mm);
the distance L1 between the surface of wafer W and the opposed face of the raw-material gas supply member 3 is in the range of from 70mm to 105mm inclusive; and
the distance L2 between the surface of wafer W and the opposed face of the discharge gas supply member 2 is in the range of from 100mm to 140mm inclusive,
a fluorine-added carbon film, which exhibits a significantly low leak current not more than 9×10⁻⁸ A/cm and has excellent heat stability, can be obtained.

This is because it can be considered that making the film forming conditions more appropriate as previously described enables to selectively generate the film-forming species containing C₄F₆, typically desired film-forming species, at a higher content, from the C₅F₈ gas used as the raw-material gas.

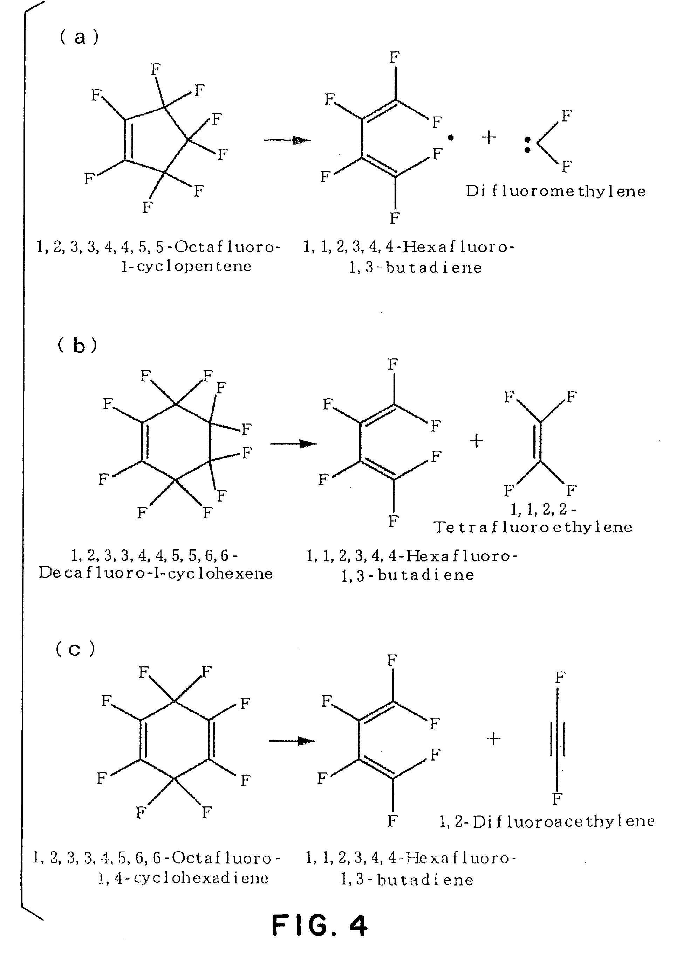

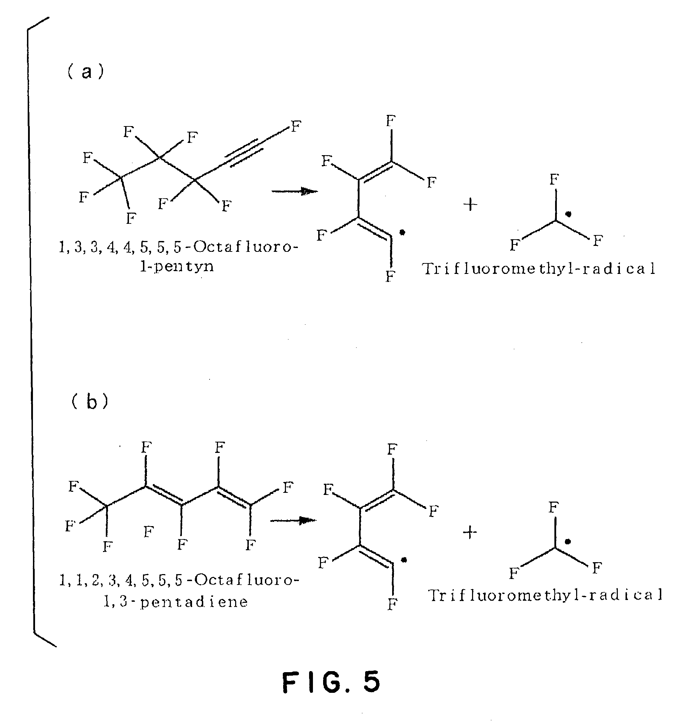

The raw-material gas is not limited to the C₅F₈ gas, but any other suitable gases of compounds, each consisting of carbon and fluorine and having a single triple bond, one or more double bonds or conjugated double bond(s), can also be used. As these gases, as shown in Figs. 4 and 5, a cyclic C₅F₈ gas (1,2,3,3,4,4,5,5-Octafluoro-l-cyclopentene (Fig. 4(a))), a cyclic C₆F₁₀ gas (1,2,3,3,4,4,5,5,6,6-Decafluoro-1-cyclohexene (Fig. 4(b))), a cyclic C₆F₈ gas (1,2,3,3,4,5,6,6-Octafluoro-1,4-cyclohexadiene (Fig. 4(c))), a C₅F₈ gas containing one triple bond (1,3,3,4,4,5,5,5-Octafluoro-1-pentyne (Fig. 5(a))), a C₅F₈ gas containing conjugated double bond (1,1,2,3,4,5,5,5-Octafluoro-1,3-pentadiene (Fig. 5(b))) and the like can be mentioned.

Now, details of finding out the usefulness of C₄F₆ ions or radicals as the film-forming species for the fluorine-added carbon film will be described. First, the inventors noted that the fluorine-added carbon film obtained by using the C₅F₈ gas as a raw-material gas exhibits unique film qualities, such as the leak properties and heat stability, which can be controlled by the film forming conditions. In fact, measurements of the film qualities of fluorine-added carbon films obtained under various film forming conditions showed that the parameters, such as the pressure in the processing vessel, microwave power, distance L1 between the wafer W and the opposed face of the raw-material gas supply member 3 and distance L2 between the wafer W and the discharge gas supply member 2, have significantly greater impact on the film qualities of the fluorine-added carbon films.

As a result, we found that the conditions, for the CVD plasma film forming apparatus utilizing the RLSA, including: the pressure in the processing vessel is in the range of from 7.32Pa (55mTorr) to 8.65Pa (65mTorr); the microwave power is in the range of from 2000W to 2300W; the distance L1 between the surface of wafer W and the opposed face of the raw-material gas supply member 3 is in the range of from 70mm to 105mm; and the distance L2 between the surface of wafer W and the discharge gas supply member 2 is in the range of from 100mm to 140mm, are more appropriate as the film forming conditions that can ensure the preferred leak properties and heat stability for the fluorine-added carbon film to be obtained. These film forming conditions will be referred to as "the found more appropriate film forming conditions" below.

In addition, simulation, by using a computer to expect that what couplings tend to be disconnected due to exertion of energy on the C₅F₈ gas, was carried out, based on the coupling energy between respective atoms constituting the C₅F₈ gas molecule. Also, simulation was performed in the same manner, concerning further tendency of disconnection of each coupling in the resultant decomposed products. Consequently, computed results that the concentration of the C₅F₈ gas is relatively high when no plasma is generated, while the C₄F₆ ions and/or C₄F₆ radicals start to be generated due to decomposition of the C₅F₈ gas when energy is exerted on the C₅F₈ gas were obtained. Moreover, with gradual increase of the energy to be exerted or over time, the amount of the C₄F₆ ions and/or C₄F₆ radicals is increased gradually. Finally, we obtained computed results that further exertion of energy or further passage of time causes decomposition of the C₄F₆ ions and/or C₄F₆ radicals into C₃F₃ ions and/or C₃F₃ radicals.

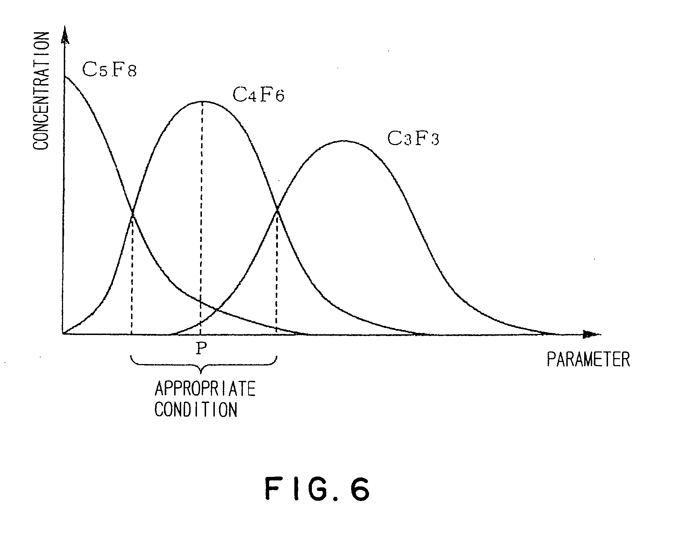

Fig. 6 represents these changes as a graph. The vertical axis indicates the gas concentration, while the horizontal axis designates a combination of various conditions (parameters) experienced by the gas. In concept, the combination of various conditions can be considered as (energy to be exerted per unit volume of the gas) × (time for which the energy is exerted). In fact, when the gas is changed into plasma by setting various conditions, various combinations of the concentration of C₅F₈ and the concentration of C₄F₆ and C₃F₃ as the decomposed products can be obtained. Fig. 6 is a graph representing expectation of such changes. This graph visualizes an aspect in which C₄F₆ and C₃F₃ are generated gradually due to decomposition of C₅F₈.

Furthermore, a mass spectrometry was conducted for each of the cases of not exerting energy on the C₅F₈ gas and of exerting energy thereon. As a result, when the energy was not exerted on the C₅F₈ gas, the peak showing the C₅F₈ gas became greater while the peak showing existence of C₄F₆ and/or C₃F₃ was not detected. Contrary, when the energy was exerted, the peak showing the C₅F₈ gas became smaller while the peak showing existence of C₄F₆ and/or C₃F₃ was positively detected. Thus, it was found that the exertion of energy on the C₅F₈ gas causes it to be decomposed, as such decreasing its amount, while generating the C₄F₆ and/or C₃F₃ which are decomposed products of the C₅F₈ gas. Accordingly, the results of the simulations described above and the results of the mass spectrometry for identifying generation of the C₄F₆ and/or C₃F₃ prove together the expectation for the decomposition expressed in the graph of Fig. 6.

Considering the above results together, the range in Fig. 6 corresponding to "the found more appropriate film forming conditions" appears to be one in which the concentration of the C₄F₆ is higher than those of the C₅F₈ and C₃F₃. Namely, as compared with "the found more appropriate film forming conditions", if the pressure in the processing vessel would be set lower, the microwave power would be lower, the distance L1 would be set smaller or the distance L2 would be set smaller, conditions such that the processing space would be relatively narrowed could be obtained, thus gas would be discharged from the chamber at an excessively high flow rate. As a result, the probability of collision between molecules would be significantly low, as such the concentration of the C₅F₈ would shift toward the higher level in Fig. 6. In fact, when measuring the amount of the C₅F₈ upon setting the pressure in the processing vessel at 6.92Pa (52mTorr), the amount of the undecomposed C₅F₈ was approximately 65%. In addition, when setting the power at 2400W, the C₅F₈ was not detected.

If the concentration of the C₅F₈ is excessively high, the film forming rate becomes lower and hence the film forming time should be lengthened. Thus, the C-C couplings are increased, leading to increase of the leak current. In addition, the heat stability is deteriorated because of decomposition of the C₅F₈ in the film or the like. Contrary, in the case of almost no presence or complete absence of the C₅F₈, the concentration of the C₃F₃ becomes higher, thus increasing the C-C couplings and raising the leak current. In addition, the heat stability is also degraded because of tendency to be decoupled in the form of CF or the like. In fact, both of the leak properties and the heat stability are degraded under the conditions being out of "the found more appropriate film forming conditions."

According to further optimization conducted by the inventors through various experiments within the range of "the found more appropriate film forming conditions," it was found that the leak current can be minimized under the conditions of: the pressure in the processing vessel of 7.71Pa (58mTorr), the microwave power of 2300W, the distance L1 of 85mm and the distance L2 of 100mm. From this point, it can be considered that the film forming conditions that make the concentration of the C₄F₆ highest correspond to the optimum conditions P (Fig. 6). As the leak current in this case, a leak current to be generated in the case of forming a fluorine-added carbon film having a 0.1µm thickness on an 8-inch sized waver W was measured, with the measuring condition set at 1MV/cm.

As described above, in the present invention, since the energy to be exerted on the C₅F₈ gas is made more proper by rendering the film forming conditions more appropriate, film-forming species containing the C₄F₆ at a higher concentration can be selectively obtained, thereby forming a fluorine-added carbon film having excellent leak properties and heat stability. By "excellent leak properties," it is meant that the leak current is 9×10⁻⁸ A/cm or lower.

We conducted film forming processes for forming fluorine-added carbon films, under the found more appropriate film forming conditions described above, by using gases of the compounds shown in Fig. 4 as the raw-material gas from which the C₄F₆ ions and/or C₄F₆ radicals can be obtained as intermediates, and then confirmed that fluorine-added carbon films which are excellent in the leak properties as well as the heat stability could be obtained, for all of the film forming processes.

Other than the C₄F₆ ions and C₄F₆ radicals, C₄F₅ ions and C₄F₅ radicals are also useful as the film-forming species. Thus, we conducted film forming processes for forming fluorine-added carbon films, under the found more appropriate film forming conditions described above, by using gases of the compounds shown in Fig. 5 as the raw-material gas from which the C₄F₅ ions and/or C₄F₅ radicals can be obtained as intermediates, and then confirmed that fluorine-added carbon films which are excellent in the leak properties as well as the heat stability could be obtained also in such processes. The reaction products depicted on the right side designated by each arrow in Figs. 4 and 5 represent ion species and radical species to be generated initially when energy is exerted on these compounds, respectively.

As described above, irrespectively of types of the plasma film forming apparatus, by conducting a film-forming process for a fluorine-added carbon film by exerting predetermined energy on the C₅F₈ gas, the film-forming process utilizing film-forming species containing the C₄F₆ in a much more proportion than the C₅F₈ and C₃F₃ can be achieved, thereby obtaining a fluorine-added carbon film having excellent film qualities, such as the leak properties and heat stability.

As shown in Fig. 6 representing expectation of decomposition, there are correlations between the concentration of the C₅F₈ and the concentration of the C₄F₆ as well as between the concentration of the C₄F₆ and the concentration of the C₃F₃, respectively. The concentration of the C₅F₈ gas can be measured at a high accuracy, for example, by the mass spectrometry and/or FTIR spectroscopy. However, for the C₄F₆ and C₃F₃, though the peak can be detected by the mass spectrometry, the level upon turning OFF the plasma is too low to measure the concentration accurately. To address this challenge, the inventors noted the possibility of determining a preferable range of the proportion of the C₄F₆, based on the C₅F₈ gas concentration.

Specifically, according to the graph representing expectation of decomposition shown in Fig. 6, the film-forming species to be obtained when the energy is exerted on the C₅F₈ gas under the found more appropriate film forming conditions correspond to the film-forming species to be obtained when the C₅F₈ gas is activated under the conditions which change the C₅F₈ gas concentration after activation due to the energy into 0.05 to 0.5 times the C₅F₈ gas concentration before activation.

Namely, since the amount of decomposed C₅F₈ and the amount of generated C₄F₆ are equal, the crossing point between the curve representing decomposition of the C₅F₈ and the curve representing generation of the C₄F₆ corresponds to the point of time the C₅F₈ gas concentration is decreased to 50% of the concentration before activation.

The mass spectrometry for the fluorine-added carbon film formed under the optimum conditions P which maximizes the concentration of the C₄F₆ showed that the peak of the C₅F₈ when energy was exerted thereon was 1/10 times the peak of the C₅F₈ when the energy was not exerted thereon. Accordingly, the optimum conditions P correspond to the point of time the undecomposed C₅F₈ gas exists in the 10% proportion (or the point of time the C₅F₈ gas is decomposed in the 90% proportion), i.e., the point of time the C₅F₈ gas concentration is decreased to 10% of the concentration before activation.

It can be considered that there is almost no C₅F₈ gas in the range where the C₄F₆ is less than the C₃F₃, and the concentration of the C₅F₈ at this point of time may be 1% of less of the concentration before activation. However, since it is difficult to measure accurately such a concentration, in the present invention, the lowest limit of the C₅F₈ is set at 5% or higher of the concentration before activation. This condition ensures that the lowest limit is on the left side relative to the crossing point between the concentration curves of C₄F₆ and C₃F₃ in Fig. 6.

As described above, the leak properties depend on the film forming conditions such that it is deteriorated when the processing conditions are out of "the found more appropriate film forming conditions." Namely, the leak properties have a relation with the ratio between the C₄F₆ and C₃F₃ in the film-forming species, in which the leak current becomes greater as the concentration of the C₃F₃ is increased. This is because the proportion of C may be higher than F in the film-forming species, causing the insulation properties to be degraded.

Accordingly, under the optimum conditions P which maximize the amount of the C₄F₆, the obtained fluorine-added carbon film exhibits the minimum leak current as apparently seen from an experiment described below. Contrary, in Fig. 6, at a point shifting left relative to the point corresponding to the optimum conditions P, where the amounts of C₄F₆ and C₅F₈ are approximately equal, or at a point shifting right relative to the optimum conditions P, where the amounts of C₄F₆ and C₃F₃ are substantially the same, the concentration of the C₄F₆ is less than measured under the optimum conditions P, thus the leak current is slightly greater than detected under the optimum conditions P.

In this way, since the range of "the found more appropriate film forming conditions" correspond well to the leak properties, the maximum leak current can be grasped within the range of "the found more appropriate film forming conditions" by obtaining fluorine-added carbon films with changes of parameters within the range of "the found more appropriate film forming conditions" and by measuring the leak current for each obtained fluorine-added carbon film. According to the experiment described below, the maximum value of the leak current of the fluorine-added carbon film formed under conditions within the range of "the found more appropriate film forming conditions" was 9×10⁻⁸ A/cm, and the optimum value of the leak current measured under the optimum conditions P (the minimum leak current) was 8.5 × 10⁻⁹ A/cm. From these obtained values, we found that the leak current of the fluorine-added carbon film formed within the range of "the found more appropriate film forming conditions" is within a range of 10 times the minimum current.

As described above, what is important of this invention is to generate selectively film-forming species containing the C₄F₆ at a higher concentration by exerting energy, which is controlled more appropriate, on the C₅F₈ gas. Therefore, in an apparatus in which the energy to be exerted on the C₅F₈ gas is too great as in the plasma film forming apparatus utilizing the ECR, for example, the time the resultant ions or radicals exists in the form of C₄F₆ is too short. Eventually, the amount of the C₄F₆ is insufficient, rendering the formation of a fluorine-added carbon film excellent in the leak properties and heat stability quite difficult. However, in the plasma film forming apparatus utilizing the ICP (Inductive Coupling Plasma), it can be considered that the present invention is applicable.

### EXAM PLES

Now, examples of experiment made for assessing the effect of the present invention will be described.

### (Experiment 1)

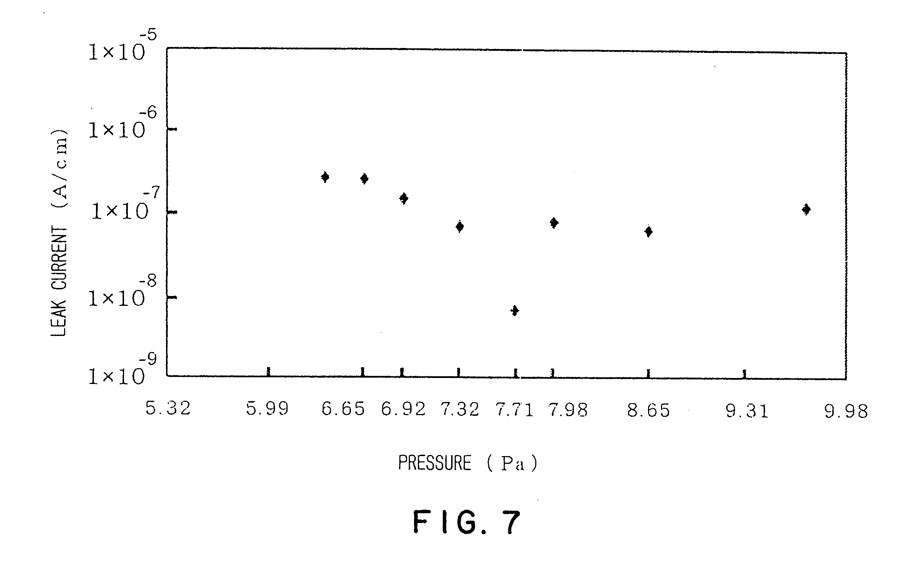

The leak current was measured in accordance with the method described above, after forming the fluorine-added carbon film with a thickness of 0.1 µm, on an 8 inch-sized wafer W, using the aforementioned plasma film forming apparatus, under the optimum conditions P which minimize the leak current, at the C₅F₈ gas flow rate of 200sccm, and at the Ar gas flow rate of 300 sccm. Similarly, the leak current was measured, after forming the fluorine-added carbon film under the same conditions, except for changing the pressure in the processing vessel, so as to check the pressure properties of the leak current. The results are shown in Fig. 7.

From the results obtained, the leak current is within the range of from 9×10⁻⁸ (A/cm) to 8. 5 × 10⁻⁹ (A/cm) under the pressure of from 7.32Pa (55mTorr) to 8.65Pa (65mTorr), showing a significantly small value. Accordingly, it is understood that the leak current depends on the pressure in the processing vessel, and that the pressure is preferably within the range of from 7.32Pa to 8.65Pa. When the pressure is 6.92Pa (52mTorr) or less, however, it is found that the leak current becomes higher than 1 × 10⁻⁷ (A/cm). Such conditions can correspond to the range in which the undecomposed C₅F₈ gas exists in the proportion of approximately 65% as described above, and the amount of the C₄F₆ generated is not sufficient.

### (Experiment 2)

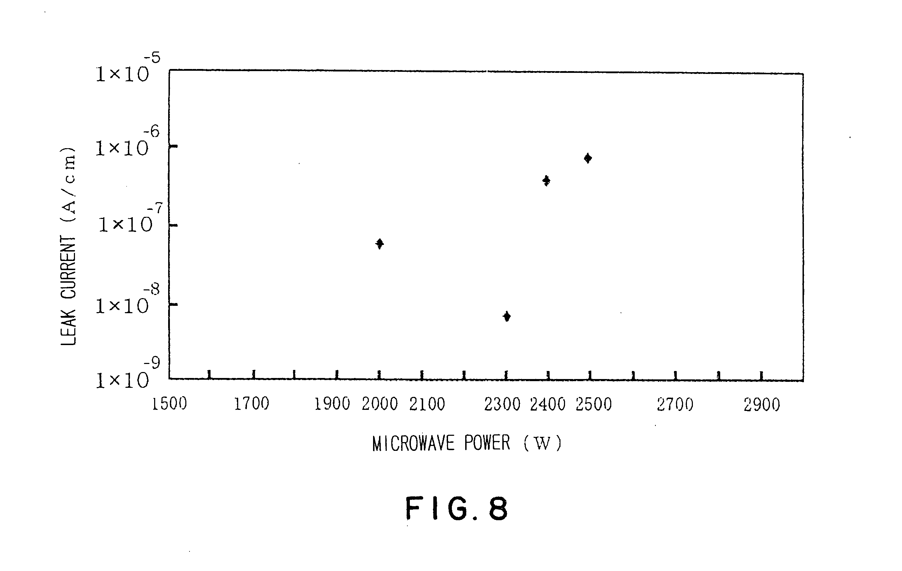

The leak current was measured in accordance with the method described above, after forming the fluorine-added carbon film, using the aforementioned plasma film forming apparatus, under the optimum conditions P, in the same manner as in the Experiment 1. In this case, the leak current was measured, after forming the fluorine-added carbon film, under the same conditions, except for changing the microwave power, so as to investigate the microwave power properties of the leak current. The results are shown in Fig. 8.

From the results obtained, within the microwave power range of 2000W to 2300W, the leak current measured is within the range of from 8.1 × 10⁻⁸ (A/cm) to 8.5 × 10⁻⁹ (A/cm), showing a significantly small value. Accordingly, it is understood that the leak current depends on the microwave power, and that the microwave power is preferably within the range of from 2000W to 2300 W. When the microwave power is 2400W or greater, however, it is found that the leak current becomes greater than 6.5x10⁻⁷ (A/cm). Such conditions can correspond to the range in which all of the C₅F₈ are decomposed, thus no C₅F₈ exist, and in which decomposition of the C₄F₆ is excessively progressed to excessively elevate the concentration of C₃F₃, and hence the amount of the C₄F₆ is not sufficient.

### (Experiment 3)

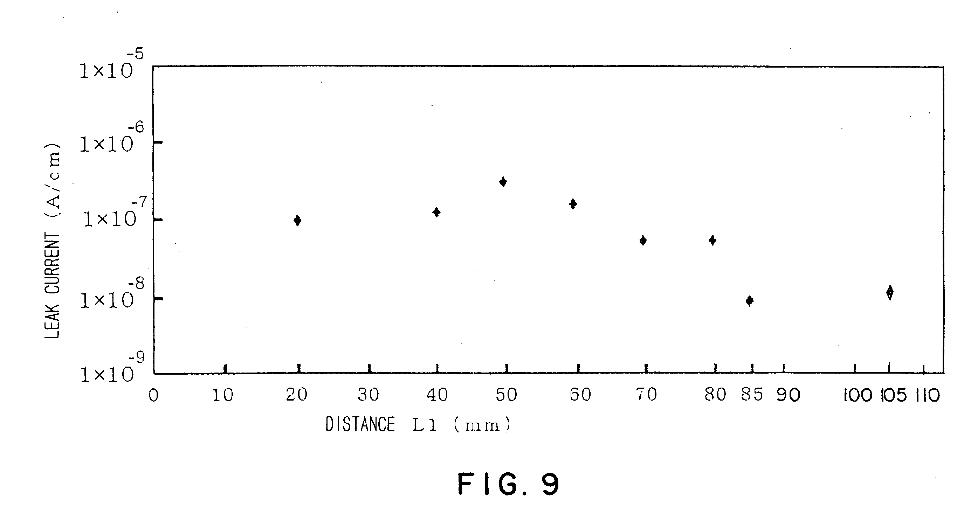

The leak current was measured in accordance with the method previously described, after forming the fluorine-added carbon film; using the aforementioned plasma film forming apparatus, under the optimum conditions P, in the same manner as in the Experiment 1. In this case, the leak current was measured, after forming the fluorine-added carbon film, under the same conditions, except for changing the distance L1 between the surface of wafer W and the opposed face of the raw-material gas supply member 3, so as to investigate the relationship between the leak current and the distance L1. The results are shown in Fig. 9. As shown in Fig. 9, when the distance L1 was 70mm, 85mm and 105mm, the leak current was 7.3×10⁻⁸ (A/cm), 9×10⁻⁹ (A/cm) and 2×10⁻⁸ (A/cm), respectively.

From the results obtained, within the range from 70mm to 105mm of the distance L1, the leak current is in the range of from 9×10⁻⁹ (A/cm) to 7.3×10⁻⁸ (A/cm), exhibiting a significantly small value. Accordingly, it is understood that the leak current depends on the distance L1, and that the distance L1 is preferably within the range of from 70mm to 105mm.

### (Experiment 4)

The leak current was measured in accordance with the method described above, after forming the fluorine-added carbon film, using the aforementioned plasma film forming apparatus, under the optimum conditions P, in the same manner as in the Experiment 1. In this experiment, the leak current was measured, after forming the fluorine-added carbon film, under the same conditions, except for changing the distance L2 between the surface of wafer W and the discharge gas supply member 2, so as to investigate the relationship between the leak current and the distance L2.

From the results obtained, within the range from 100mm to 140mm of the distance L2, it was found that the leak current was less than 1×10⁻⁸ (A/cm), exhibiting a significantly small value. We consider that the distance L2 may have less influence on the leak current than the distance L1 described above does. However, if the distance L2 is excessively greater, there may be a risk to deteriorate the film forming speed. However, if it is set at approximately 140mm, such deterioration of the film forming speed needs not to be considered.

### (Experiment 5)

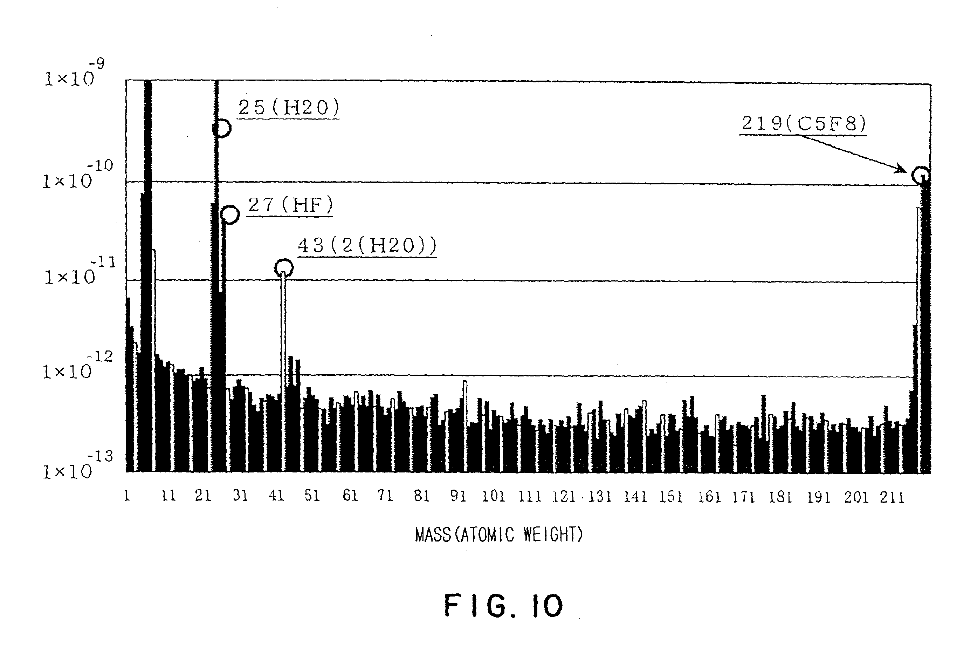

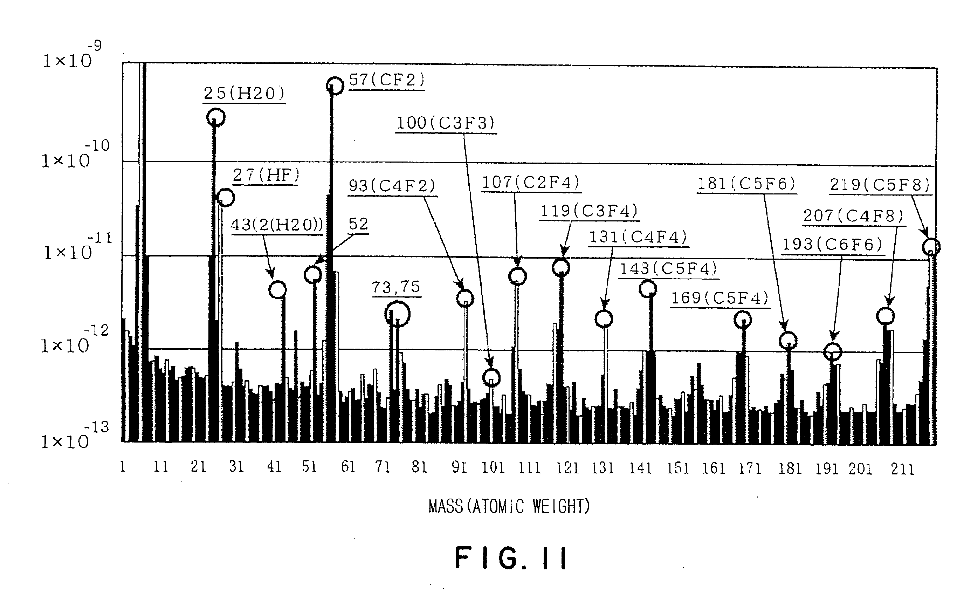

The mass spectrum was measured, after forming the fluorine-added carbon film, using the aforementioned plasma film forming apparatus, under the optimum conditions P, in the same manner as in the Experiment 1, except for not generating plasma. Also, the mass spectrum was measured, under the same conditions, in the same manner, with the plasma generation. The results obtained in the case of not generating plasma are shown in Fig. 10, and those obtained with plasma generation are shown in Fig. 11, respectively.

Since the factors of at least (energy) × (time) are included in the horizontal axis of Fig. 6, the point of measuring the spectrum is very critical. In this experiment, the measuring point MP was determined as a point located lower by 10cm than the wafer placing face of the table 11. At the measuring point MP, the energy is not exerted on the gas, and the gas is hence no longer decomposed.

From the results, when plasma is not generated, while the peak of C₅F₈ is detected at the mass 219, the peak corresponding to the C₄F₆ or C₃F₃ is not seen. On the other hand, when plasma is generated, the peak of C₅F₈ at the mass 219 and the peak of C₄F₆ at the mass 169 are detected, and the peak C₃F₃ at the mass 100 is also detected. Furthermore, it was found that the peak of the mass 219 is approximately 1/10 times the case where the plasma was not generated.

From the above, it is understood that when the fluorine-added carbon film is formed under the optimum conditions, the C₅F₈ gas is decomposed while the C₄F₆ and/or C₃F₃ is generated, and that the concentration of the C₅F₈ gas of this case is approximately 1/10 times the case where the plasma energy is not exerted, and at this point of time, 90% of the C₅F₈ gas has been decomposed.

In the above mass spectroscopy, the mass spectrum was measured with Li ions adhered to an object to be measured. Since the probability of adherence of the Li ions varies with materials, the comparison of the abundance between different materials, such as C₅F₈ and C₄F₆, can not be applicable. However, with respect to the same material, the comparison of the abundance can be useful based on the magnitudes of respective peaks.

## Claims

1. A plasma film forming method for forming a fluorine-added carbon film, from film-forming species containing C₄F₆ or C₄F₅ obtained by activating a raw-material gas of a compound consisting of carbon and fluorine and having one triple bond, one or more double bonds or conjugated double bond, based on energy of a microwave,
wherein the raw-material gas is activated to make a concentration of the raw-material gas after activation in the range of from 0.05 times to 0.5 times a concentration of the raw-material gas before activation.

2. The plasma film forming method according to claim 1, wherein the compound having one triple bond is Octafluoropentyne.

3. The plasma film forming method according to claim 1, wherein the compound having one or more double bonds is selected from the group consisting of Octafluorocyclopentene, Decafluorocyclohexene, Octafluorocyclohexadiene.

4. The plasma film forming method according to claim 1, wherein the compound having conjugated double bond is Octafluoropentadiene.

5. A plasma film forming apparatus for forming a fluorine-added carbon film on a surface of a substrate, from film-forming species containing C₄F₆ or C₄F₅ obtained by activating a raw-material gas of a compound consisting of carbon and fluorine and having one triple bond, one or more double bonds or conjugated double bond, based on energy of a microwave, the apparatus comprising:
an airtight processing vessel in which a table for placing the substrate thereon is provided;
an exhaust system configured to discharge an atmosphere in the processing vessel;
a raw-material gas supply system configured to supply the raw-material gas into the processing vessel at a controlled flow rate;
a raw-material gas supply member having a face opposed to the table, the opposed face being formed with raw-material gas supply holes, the raw-material gas supply member being configured to discharge the raw-material gas supplied from the raw-material gas supply system into the processing vessel via the supply holes;
a radial line slot antenna provided opposing to the table;
a microwave supply system configured to supply a microwave to the antenna at a controlled power; and
a controller configured, upon forming the film, to control the exhaust system, the raw-material gas supply system and the microwave supply system to activate the raw-material gas to make a concentration of the raw-material gas after activation in the range of from 0.05 times to 0.5 times a concentration of the raw-material gas before activation.

6. A plasma film forming apparatus for forming a fluorine-added carbon film on the surface of a substrate, from film-forming species containing C₄F₆ or C₄F₅ obtained by activating a raw-material gas of a compound consisting of carbon and fluorine and having one triple bond, one or more double bonds or conjugated double bond, based on energy of a microwave, the apparatus comprising:
an airtight processing vessel in which a table for placing the substrate thereon is provided;
an exhaust system configured to discharge an atmosphere in the processing vessel;
a raw-material gas supply system configured to supply the raw-material gas into the processing vessel at a controlled flow rate;
a raw-material gas supply member having a face opposed to the table, the opposed face being formed with raw-material gas supply holes, the raw-material gas supply member being configured to discharge the raw-material gas supplied from the raw-material gas supply system into the processing vessel via the supply holes;
a discharge gas supply system configured to supply a discharge gas into the processing vessel at a controlled flow rate;
a discharge gas supply member having a face opposed to the table, the opposed face being formed with discharge gas supply holes, the discharge gas supply member being configured to discharge the discharge gas supplied from the discharge gas supply system into the processing vessel via the supply holes;
a radial line slot antenna provided opposing to the table; and
a microwave supply system configured to supply a microwave to the antenna at a controlled power,
wherein the distance between the surface of the substrate on the table and the opposed face of the raw-material gas supply member is in the range of from 70mm to 105mm,
wherein the distance between the surface of the substrate on the table and the opposed face of the discharge gas supply member is in the range of from 100mm to 140mm, and
wherein the apparatus further comprises a controller configured, upon forming the film, to control the exhaust system, the raw-material gas supply system and the discharge gas supply system to make a pressure in the processing vessel in the range of from 7.32Pa to 8.65Pa as well as to control the microwave supply system to make the power of the microwave supplied to the antenna member in the range of from 2000W to 2300W.

7. A storage medium for use in forming a fluorine-added carbon film on the surface of a substrate, from film-forming species containing C₄F₆ or C₄F₅ obtained by activating a raw-material gas of a compound consisting of carbon and fluorine and having one triple bond, one or more double bonds or conjugated double bond, based on energy of a microwave, by using a plasma film forming apparatus comprising:
an airtight processing vessel in which a table for placing the substrate thereon is provided;
an exhaust system configured to discharge an atmosphere in the processing vessel;
a raw-material gas supply system configured to supply the raw-material gas into the processing vessel at a controlled flow rate;
a raw-material gas supply member having a face opposed to the table, the opposed face being formed with raw-material gas supply holes, the raw-material gas supply member being configured to discharge the raw-material gas supplied from the raw-material gas supply system into the processing vessel via the supply holes;
a radial line slot antenna provided opposing to the table; and
a microwave supply system configured to supply a microwave to the antenna at a controlled power,
wherein the storage medium stores therein a program configured to control the exhaust system, the raw-material gas supply system and the microwave supply system to activate the raw-material gas to make a concentration of the raw-material gas after activation in the range of from 0.05 times to 0.5 times a concentration of the raw-material gas before activation.

8. A storage medium for use in forming a fluorine-added carbon film on the surface of a substrate, from film-forming species containing C₄F₆ or C₄F₅ obtained by activating a raw-material gas of a compound consisting of carbon and fluorine and having one triple bond, one or more double bonds or conjugated double bond, based on energy of a microwave, by using a plasma film forming apparatus comprising:
an airtight processing vessel in which a table for placing the substrate thereon is provided;
an exhaust system configured to discharge an atmosphere in the processing vessel;
a raw-material gas supply system configured to supply the raw-material gas into the processing vessel at a controlled flow rate;
a raw-material gas supply member having a face opposed to the table, the opposed face being formed with raw-material gas supply holes, the raw-material gas supply member being configured to discharge the raw-material gas supplied from the raw-material gas supply system into the processing vessel via the supply holes;
a discharge gas supply system configured to supply a discharge gas into the processing vessel at a controlled flow rate;
a discharge gas supply member having a face opposed to the table, the opposed face being formed with discharge gas supply holes, the discharge gas supply member being configured to discharge the discharge gas supplied from the discharge gas supply system into the processing vessel via the supply holes;
a radial line slot antenna provided opposing to the table; and
a microwave supply system configured to supply a microwave to the antenna at a controlled power,
wherein the distance between the surface of the substrate on the table and the opposed face of the raw-material gas supply member is in the range of from 70mm to 105mm,
wherein the distance between the surface of the substrate on the table and the opposed face of the discharge gas supply member is in the range of from 100mm to 140mm, and
wherein the storage medium stores therein a program configured to control the exhaust system, the raw-material gas supply system and the discharge gas supply system to make a pressure in the processing vessel in the range of from 7.32Pa to 8.65Pa as well as to control the microwave supply system to make the power of the microwave supplied to the antenna member in the range of from 2000W to 2300W.
